# FASCICULE DE BREVET EUROPEEN

(11) **EP 3 715 208 B1**
(45) Date de publication et mention de la délivrance du brevet: **08.12.2021**
(21) Numéro de dépôt: 20165315.1
(22) Date de dépôt: 24.03.2020
(51) Int. Cl.: B61C 17/00, B60L 15/00, H05K 7/14

(54) **COFFRE D'UN CONVERTISSEUR AUXILIAIRE POUR UN VEHICULE FERROVIAIRE ET CONVERTISSEUR AUXILIAIRE CORRESPONDANT**
KASTEN EINES HILFSSTROMWANDLERS FÜR EIN SCHIENENFAHRZEUG, UND ENTSPRECHENDER HILFSSTROMWANDLER
BOX OF AN AUXILIARY CONVERTER FOR A RAILWAY VEHICLE AND CORRESPONDING AUXILIARY CONVERTER

(30) Priorité: 26.03.2019 FR 1903147
(43) Date de publication de la demande: 30.09.2020
(73) Titulaire: ALSTOM Transport Technologies, 93400 Saint-Ouen (FR)
(72) Inventeur: CARDARELLI, Felice, 7134 Leval-Trahegnies (BE); DELANNOY, Germain, 59600 MAUBEUGE (FR)
(74) Mandataire: Lavoix

(56) Documents cités:
- DE-U1- 29 719 195
- JP-A- 2005 039 914
- JP-A- 2011 151 924

## Description

L'invention a pour domaine celui des coffres de convertisseur auxiliaire pour véhicule ferroviaire.

Par véhicule ferroviaire, on entend tout type de véhicule guidé, en particulier les trains, métros (sur pneus ou sur rails), tramways, etc.

On connait des convertisseurs auxiliaires comportant un coffre, constitué d'un châssis obturé par un capot amovible, et des composants électriques, montés à l'intérieur du châssis, soit directement sur les faces internes de celui-ci, soit sur des cartes insérées à l'intérieur de celui-ci,

Cependant, par exemple lors d'opérations de maintenance, l'opérateur doit ouvrir le coffre en démontant le capot, puis accéder au volume intérieur du coffre, identifier le ou les composants défaillants, puis les déposer afin de les remplacer par des composants neufs.

Or, l'ergonomie des coffres connus ne facilite pas ce genre d'opérations. En particulier, un seul opérateur à la fois peut accéder à l'intérieur du coffre.

Le document JP 2011 151 124 divulgue un coffre d'un convertisseur auxiliaire pour un véhicule ferroviaire, le convertisseur auxiliaire étant du type modulaire, c'est-à-dire dont chacune des fonctions est réalisée par un module fonctionnel associé, le coffre étant caractérisé en ce qu'il comporte une partie fixe, de fixation du convertisseur auxiliaire sur le véhicule ferroviaire, et au moins une partie mobile, de réception de chacun des modules fonctionnels du convertisseur auxiliaire,

L'invention a donc pour but de répondre à ce problème, notamment en proposant un coffre présentant une ergonomie améliorée. L'invention a pour objet un coffre d'un convertisseur auxiliaire selon les revendications annexées.

L'invention et ses avantages seront mieux compris à la lecture de la description détaillée qui va suivre d'un mode de réalisation particulier, donné uniquement à titre d'exemple illustratif et non limitatif, la description étant faite en se référant à la figure annexée correspondant à une vue en perspective d'un convertisseur auxiliaire selon l'invention.

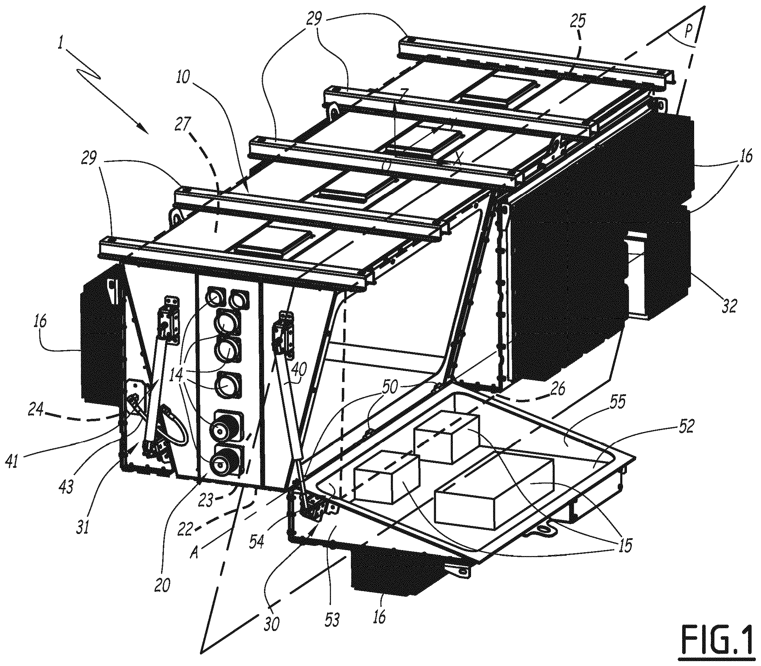

Un convertisseur auxiliaire pour véhicule ferroviaire est représenté sur la figure 1.

Ce convertisseur auxiliaire 1 est du type modulaire, c'est-à-dire que, d'une part, ses différents composants électriques et/ou électroniques sont répartis dans des modules, chaque module réalisant une fonction particulière du convertisseur, et, d'autre part, ces différents modules sont mécaniquement indépendants les uns des autres. Il est alors possible, par exemple lors d'une opération de maintenance, de déposer un module défaillant en déconnectant les câbles électriques auxquels il est relié et en le désolidarisant de son support, puis de le remplacer par un module similaire opérationnel, que l'on monte sur le support et que l'on connecte aux différents câbles. Ces étapes s'effectuent sans affecter les autres modules du convertisseur. Un tel convertisseur auxiliaire modulaire présente notamment l'avantage d'une fabrication et d'une maintenance aisée par rapport à l'état de la technique.

Le convertisseur auxiliaire 1 comporte un coffre 10, qui renferme intérieurement l'ensemble des modules fonctionnels, en particulier pour les protéger des agressions extérieures au cours du fonctionnement du convertisseur auxiliaire et de l'exploitation du véhicule ferroviaire équipé de ce convertisseur auxiliaire.

Est associé au coffre 10, un référentiel de centre O et d'axe X, Y et Z. Lorsque le coffre est monté sur le véhicule ferroviaire, l'axe Z est vertical, l'axe Y est parallèle à un axe longitudinal du véhicule, et l'axe X est parallèle à un axe transversal du véhicule.

Le coffre 10 est symétrique par rapport à un plan longitudinal médian YZ et par rapport à un plan transversal médian XZ. Ces plans délimitent dans le coffre 10 quatre compartiments.

Le coffre 10 comporte une partie fixe 20 formant un bâti destiné à être fixé sur le véhicule ferroviaire, par exemple sous la caisse d'une voiture de ce véhicule au moyen d'une pluralité de traverses.

Le coffre 10 comporte au moins une partie mobile qui est articulée à la partie fixe 20 et propre à être déplacée depuis une première position, dans laquelle le compartiment associé est fermé, vers une seconde position, dans lequel le compartiment associé est ouvert, et inversement de la seconde position vers la première position.

Dans le mode de réalisation préféré, représenté sur la figure, le coffre 10 comporte quatre parties mobiles, mécaniquement indépendantes les unes des autres.

Sur la figure, trois parties mobiles sont représentées et référencées respectivement 30, 31 et 32.

Les parties mobiles 31 et 32 sont représentées dans la première position, le compartiment associé étant fermé.

La partie mobile 30 est représentée dans la seconde position, le compartiment associé étant ouvert.

Dans ce qui suit, la partie mobile 30 sera plus particulièrement décrite, sachant qu'une description similaire pourrait être faite pour les autres partie mobiles.

La partie mobile 30 est destinée à recevoir des modules fonctionnels du convertisseur auxiliaire. L'ensemble des modules fonctionnels du convertisseur 1 sont montés sur les parties mobiles de celui-ci de sorte que la partie fixe 20 ne supporte aucun module fonctionnel.

La partie fixe 20 comporte extérieurement, de préférence sur la face d'extrémité longitudinale 23 du coffre 10, des connecteurs, référencés de manière générale par le chiffre 14, pour relier le convertisseur auxiliaire 1, d'une part, à une source de puissance électrique haute tension et, d'autre part, à une ou plusieurs charges qu'il convient d'alimenter avec une tension basse, telle(s) que par exemple des climatiseurs disposés dans les voitures du véhicule ferroviaire équipé du convertisseur auxiliaire.

La partie fixe 20 comporte intérieurement uniquement des câbles (non représentés sur la figure) permettant de relier les connecteurs aux différents modules fonctionnels implantés sur chaque partie mobile 30 ou les modules fonctionnels entre eux, notamment lorsqu'ils sont implantés sur des parties mobiles différentes.

Dans le mode de réalisation représenté sur la figure 1, le coffre 10 prend la forme, lorsqu'il est fermé, d'un parallélépipède rectangle, de hauteur h, de longueur I et de profondeur w. Ce parallélépipède rectangle est représenté en traits interrompus sur la figure. Les faces d'extrémité longitudinales 23 et 25 de ce parallélépipède rectangle sont parallèles au plan XZ, les faces inférieure 22 et supérieure 27 sont parallèles au plan XY et les faces avant 26 et arrière 24 sont parallèles au plan YZ. La face supérieure 27 est munie d'une pluralité de profilés 29 pour la fixation du coffre 10 sous la caisse d'un véhicule ferroviaire.

Ce parallélépipède rectangle est subdivisé, selon un plan de joint P, de manière à délimiter, d'un côté, les parties mobiles 30 et 32, et, de l'autre côté, la partie fixe 20.

Plus précisément, le plan de joint P est un plan parallèle à la direction longitudinale Y et venant couper les faces d'extrémités longitudinales 23, 25 du parallélépipède rectangle selon une ligne, avantageusement oblique.

La partie mobile 30 est articulée à la partie fixe 20 le long d'une liaison pivot, dont l'axe A repose à l'intersection du plan de joint P et de la face inférieure du coffre 10. L'axe A est ainsi parallèle aux arêtes du parallélépipède rectangle connectant les faces d'extrémités longitudinales 23 et 25 entre elles, ou encore parallèle à la direction longitudinale Y.

L'axe A ne coïncide donc pas avec l'arête du parallélépipède rectangle entre la face inférieure 22 et la face avant 26. En déplaçant l'axe A vers le plan longitudinal médian YZ, on limite l'envergure du coffre 10 lorsque ses parties mobiles sont dans la seconde position, le coffre étant alors ouvert. L'espace sur le véhicule ferroviaire à réserver pour le convertisseur auxiliaire 1 de manière à autoriser l'ouverture du coffre 10 est donc réduit, ce qui permet une meilleure intégration au véhicule ferroviaire.

Les parties fixe 20 et mobile 30 présentent des formes complémentaires l'une de l'autre pour retrouver, dans la première position de la partie mobile 30 par rapport à la partie fixe 20, la forme parallélépipédique rectangle du coffre 10. Dans le mode de réalisation représenté, les parties fixe 20 et mobile 30 venant en appui l'une de l'autre dans le plan de joint P, oblique, la partie fixe 20 présente la forme d'un prisme trapézoïdal. Sur la figure, le plan de joint P passant par l'arête entre la face supérieure 27 et la face avant du coffre 10, la partie mobile 30 prend la forme d'un prisme triangulaire.

La partie mobile 30 comporte une paroi principale 32, correspondant à la face avant du parallélépipède rectangle du coffre 10.

Sur une surface intérieure de la paroi 52, c'est-à-dire la surface orientée vers l'intérieur du coffre 10 lorsque celui-ci est fermé, sont montés différents modules fonctionnels du convertisseur auxiliaire. Sur la figure, ils sont référencés de manière générale par le chiffre 15.

Sur la surface extérieure de la paroi 52, c'est-à-dire la surface orientée vers l'extérieur du coffre 10 lorsque celui-ci est fermé, sont montés différents dispositifs de refroidissements, tels que les dispositifs de refroidissement à ailettes 16, notamment visibles sur la partie mobile 32. Ceci permet un refroidissement des modules fonctionnels, à travers la paroi 52, par circulation d'air frais entre les ailettes.

La paroi 52 est munie d'un bord tombé 54 et de bords latéraux 53 et 55. Le bord tombé 54 correspond à une portion de la face inférieure du coffre 10 et est sensiblement rectangulaire.

Le bord latéral 53 correspond à une portion de la face d'extrémité du coffre 10.

Les bords latéraux 53 et 55 sont de forme triangulaire.

Ainsi, la partie mobile 20 délimite un volume de réception des modules fonctionnels du convertisseur auxiliaire 1. Eventuellement, certains des modules fonctionnels, de taille importante peuvent faire saillie hors de ce volume et par conséquent être partiellement reçu dans le volume délimité par la partie fixe 20 lors de la fermeture du compartiment associé, le volume de la partie fixe 20 étant essentiellement libre et dimensionné pour permettre la réception de ces modules volumineux lorsque la partie mobile 30 est rabattue sur la partie fixe 20.

Le rebord libre du bord tombé 54 porte une première plaque d'une charnière 50 de liaison de la partie mobile 30 sur la partie fixe 20. La seconde plaque de la charnière 50 est montée sur un montant inférieur de la partie fixe 20.

Le coffre 10 est équipé d'un vérin 40, destinés à faciliter le déplacement de la partie mobile 30 entre sa première position et sa seconde position. Le vérin 40 permet également de maintenir la partie mobile 30 dans sa seconde position. Le vérin 40 permet de reprendre le poids de la partie mobile 30, portant des modules fonctionnels du convertisseur auxiliaire.

L'extrémité libre du cylindre du vérin 40 est couplée à la paroi d'extrémité 23 de la partie fixe 20, tandis que l'extrémité libre de la tige du vérin 40 est couplée au bord latéral 53 de la partie mobile 30.

Sur la figure, est également visible le vérin 41 associé à la partie mobile 31.

On notera sur la figure, la présence d'un câble de retenue 43 connectant la partie mobile 31 à la partie fixe 20, de manière à limiter la course du vérin 41 lors de l'ouverture.

Avantageusement, un câble électrique connecte électriquement la partie mobile 30, 31, 32 à la partie fixe de manière à placer la masse de la partie mobile au potentiel de la masse de la partie mobile 20, et donc du véhicule ferroviaire, de manière notamment à éviter toute électrocution de l'opérateur intervenant sur la partie mobile. Le câble est, par exemple, prévu à l'intérieur du coffre et n'est pas visible sur la figure.

Lorsque le coffre 10 est monté sur un véhicule ferroviaire, la seconde position adoptée par la partie mobile 30 est telle que sa paroi principale 52 de la partie mobile 30 est disposée sensiblement horizontalement.

Ainsi, les modules fonctionnels du convertisseur 1 sont clairement exposés à l'opérateur, qui de plus y accède facilement. En particulier, le fait que la partie mobile 30 ne comporte pas de bord avant, facilite l'accès au volume délimité par la partie mobile.

L'espace de travail au-dessus de la partie mobile dans sa seconde position permet l'implantation ou l'extraction d'un module fonctionnel, sans interférence avec la partie fixe.

De plus, plusieurs opérateurs peuvent simultanément intervenir sur un même convertisseur.

Enfin, la partie mobile 30 peut être facilement détachée de la partie fixe 20 et remplacée dans son intégralité. Ainsi, si le convertisseur d'un véhicule ferroviaire est défaillant à cause d'un des modules montés sur la partie mobile 30, cette dernière peut être remplacée dans son intégralité par une partie mobile identique déjà équipée de module. Cela permet de limiter le temps d'arrêt du véhicule ferroviaire, qui peut immédiatement repartir. La partie mobile démontée est envoyée à l'atelier pour identification et remplacement du ou des modules fonctionnels défaillants. La partie mobile constitue ainsi un LRU, pour « line-replaceable unit », c'est-à-dire une unité pouvant être remplacée rapidement.

Le coffre présenté ci-dessus permet donc de simplifier la fabrication et la maintenance du convertisseur auxiliaire correspondant.

## Revendications

1. Coffre (10) d'un convertisseur auxiliaire (1) pour un véhicule ferroviaire, le convertisseur auxiliaire (1) étant du type modulaire, c'est-à-dire dont chacune des fonctions est réalisée par un module fonctionnel (15) associé, le coffre (10) comportant une partie fixe (20), de fixation du convertisseur auxiliaire (1) sur le véhicule ferroviaire, et au moins une partie mobile (30, 31, 32), de réception de chacun des modules fonctionnels (15) du convertisseur auxiliaire (1), le coffre étant **caractérisé en ce que** la partie mobile (30, 31, 32) est articulée à la partie fixe (20) pour être déplaçable entre une première position, dans laquelle le coffre (10) est fermé pour protéger les modules fonctionnels alors situés à l'intérieur du volume délimité par le coffre (10) fermé, et une seconde position, dans laquelle le coffre (10) est ouvert pour accéder aux modules fonctionnels alors situés à l'extérieur du volume délimité par le coffre (10) fermé,
le coffre ayant, dans la première position de ladite au moins une partie mobile (30), une forme extérieure correspondant sensiblement à un parallélépipède rectangle, un plan de joint (P) subdivisant le coffre (10) de manière à y délimiter la partie fixe (20) et ladite au moins une partie mobile (30),
le plan de joint (P) coupant obliquement des faces d'extrémité (23, 25) du parallélépipède rectangle que forme le coffre (10).

2. Coffre (10) selon la revendication 1, comportant au moins un vérin (40, 41), une extrémité du vérin étant couplée à la partie fixe (20) et l'autre extrémité dudit vérin étant couplée à ladite au moins une partie mobile (31), chaque vérin permettant de maintenir la partie mobile (31) à laquelle il est couplé dans la seconde position et de faciliter un mouvement de la partie mobile (31) à laquelle il est couplé entre ses première et seconde positions.

3. Coffre (10) selon l'une quelconque des revendications 1 à 2, dans lequel la partie mobile (30, 31, 32) est liée à la partie fixe par une liaison pivot.

4. Coffre selon l'une quelconque des revendications 1 à 3, dans lequel un axe (A) de la liaison pivot repose dans le plan de joint (P) et est parallèle aux arrêtes du parallélépipède rectangle que forme le coffre qui relie les faces d'extrémité (23, 25) dudit parallélépipède rectangle.

5. Coffre (10) selon l'une quelconque des revendications 1 à 4, dans lequel la partie fixe (30) comporte des connecteurs (14) pour connecter le convertisseur auxiliaire (1), d'une part, à une source de puissance électrique et, d'autre part, à au moins une charge électrique, et des câbles reliant les connecteurs aux modules fonctionnels (15) du convertisseur auxiliaire (1) montés dans ladite au moins une partie mobile (30) du coffre (10).

6. Coffre (10) selon l'une quelconque des revendications 1 à 5, dans lequel, le coffre (10) étant monté sur un véhicule ferroviaire, la paroi (52) de la partie mobile (30) sur laquelle sont montés les modules fonctionnels (15) du convertisseur auxiliaire (1) est sensiblement horizontale dans la seconde position de ladite partie mobile.

7. Coffre (10) selon l'une quelconque des revendications 1 à 6, dans lequel une paroi (52) de la partie mobile (30, 31, 32) sur une première face de laquelle sont montés les modules fonctionnels (15) du convertisseur auxiliaire (1), est munie, sur sa seconde face, d'au moins un dispositif de refroidissement (16).

8. Convertisseur auxiliaire (1) pour véhicule ferroviaire, **caractérisé en ce qu'**il est du type modulaire, c'est-à-dire dont chacune des fonctions est réalisée par un module fonctionnel (15) associé, et **en ce qu'**il comporte un coffre (10) conforme à l'une quelconque des revendications 1 à 7, chacun des modules fonctionnel (15) du convertisseur étant fixé sur une paroi (52) d'une partie mobile (30, 31, 32) du coffre (10) qui est orientée vers l'intérieur du coffre (10) dans la première position de ladite partie mobile.

## Patentansprüche

1. Kasten (10) eines Hilfsstromwandlers (1) für eine Schienenfahrzeug, wobei der Hilfsstromwandler (1) der modularen Art ist, d. h. wobei jede der Funktionen durch ein zugewiesenes funktionelles Modul (15) durchgeführt wird, wobei der Kasten (10) einen festen Teil (20) zur Befestigung des Hilfswandlers (1) auf dem Schienenfahrzeug und mindestens einen beweglichen Teil (30, 31, 32) zur Aufnahme jedes der funktionellen Module (15) des Hilfswandlers (1) umfasst, wobei der Kasten **dadurch gekennzeichnet ist, dass** der bewegliche Teil (30, 31, 32) mit dem festen Teil (20) gelenkig verbunden ist, um zwischen einer ersten Position, in der der Kasten (10) geschlossen ist, um die funktionellen Module zu schützen, die sich nun im Inneren des Volumens befinden, das vom geschlossenen Kasten (10) begrenzt ist, und einer zweiten Position, in der der Kasten (10) offen ist, um auf die funktionellen Module zuzugreifen, die sich nun außerhalb des Volumens befinden, das vom geschlossenen Kasten (10) begrenzt ist, verschoben werden zu können, wobei der Kasten in der ersten Position des mindestens einen beweglichen Teils (30) eine äußere Form aufweist, die im Wesentlichen einem rechtwinkligen Parallelepiped entspricht, wobei eine Trennebene (P) den Kasten (10) derart unterteilt, dass sie den festen Teil (20) und den mindestens einen beweglichen Teil (30) dort begrenzt.
wobei die Trennebene (P) Endseiten (23, 25) des rechtwinkligen Parallelepipeds, das der Kasten (10) bildet, schräg schneidet.

2. Kasten (10) nach Anspruch 1, umfassend mindestens einen Zylinder (40, 41), wobei ein Ende des Zylinders an den festen Teil (20) gekoppelt ist und das andere Ende des Zylinders an den mindestens einen beweglichen Teil (31) gekoppelt ist, wobei jeder Zylinder ermöglicht, den beweglichen Teil (31), an den er gekoppelt ist, in der zweiten Position zu halten und eine Bewegung des beweglichen Teils (31), an den er gekoppelt ist, zwischen seiner ersten Position und zweiten Position zu erleichtern.

3. Kasten (10) nach einem der Ansprüche 1 bis 2, wobei der bewegliche Teil (30, 31, 32) mit dem festen Teil durch eine Schwenkverbindung verbunden ist.

4. Kasten nach einem der Ansprüche 1 bis 3, wobei eine Achse (A) der Schwenkverbindung auf der Trennebene (P) ruht und parallel zu den Aussetzungen des rechtwinkligen Parallelogramms ist, die der Kasten bildet, der die Endseiten (23, 25) des rechtwinkligen Parallelogramms verbindet.

5. Kasten (10) nach einem der Ansprüche 1 bis 4, wobei der feste Teil (30) Verbinder (14) umfasst, um den Hilfsstromwandler (1) einerseits mit einer elektrischen Leistungsquelle und, andererseits mit mindestens einer elektrischen Last zu verbinden, und Kabel, die die Verbinder mit den funktionellen Modulen (15) des Hilfswandlers (1) verbinden, die in dem mindestens einen beweglichen Teil (30) des Kastens (10) montiert sind.

6. Kasten (10) nach einem der Ansprüche 1 bis 5, wobei, da der Kasten (10) auf einem Schienenfahrzeug montiert ist, die Wand (52) des beweglichen Teils (30), auf der die funktionellen Module (15) des Hilfswandlers (1) montiert sind, im Wesentlichen horizontal in der zweiten Position des beweglichen Teils ist.

7. Kasten (10) nach einem der Ansprüche 1 bis 6, wobei die Wand (52) des beweglichen Teils (30, 31, 32), bei der auf einer ersten Seite die funktionellen Module (15) des Hilfswandlers (1) montiert sind, auf ihrer zweiten Seite mit mindestens einer Kühlvorrichtung (16) ausgestattet ist.

8. Hilfsstromwandler (1) für ein Schienenfahrzeug, **dadurch gekennzeichnet, dass** es von der modularen Art ist, d. h. wobei jede der Funktionen durch ein zugewiesenes funktionelles Modul (15) durchgeführt ist, und dadurch, dass es einen Kasten (10) gemäß einem der Ansprühe 1 bis 7 umfasst, wobei jedes der funktionellen Module (15) des Wandlers auf einer Wand (52) eines beweglichen Teils (30, 31, 32) des Kastens (10) befestigt ist, die auf das Innere des Kastens (10) in der ersten Position des beweglichen Teils gerichtet ist.

## Claims

1. A box (10) of an auxiliary converter (1) for a railway vehicle, the auxiliary converter (1) being of the modular type, that is to say, whereof each of the functions is performed by an associated functional module (15), the box (10) including a fixed part (20), for fastening the auxiliary converter (1) on the railway vehicle, and at least one moving part (30, 31, 32), for receiving each of the functional modules (15) of the auxiliary converter (1), the box being **characterized in that** the moving part (30, 31, 32) is hinged to the fixed part (20) so as to be movable between a first position, in which the box (10) is closed to protect the functional modules then located inside the volume delimited by the closed box (10), and a second position, in which the box (10) is open to access the functional modules then located outside the volume delimited by the closed box (10),
the box having, in the first position of said at least one moving part (30), an outer shape substantially corresponding to a rectangular parallelepiped, a parting plane (P) subdividing the box (10) so as to delimit the fixed part (20) and said at least one moving part (30) therein,
the parting plane (P) obliquely intersecting end faces (23, 25) of the rectangular parallelepiped formed by the box (10).

2. The box (10) according to claim 1, including at least one jack (40, 41), one end of the jack being coupled to the fixed part (20) and the other end of said jack being coupled to said at least one moving part (31), each jack making it possible to keep the moving part (31) to which it is coupled in the second position and to facilitate a movement of the moving part (31) to which it is coupled between its first and second positions.

3. The box (10) according to any one of claims 1 to 2, wherein the moving part (30, 31, 32) is connected to the fixed part by a pivot link.

4. The box according to any one of claims 1 to 3, wherein an axis (A) of the pivot link rests in the parting plane (P) and is parallel to the edges of the rectangular parallelepiped formed by the box that connects the end faces (23, 25) of said rectangular parallelepiped.

5. The box (10) according to any one of claims 1 to 4, wherein the fixed part (30) includes connectors (14) for connecting the auxiliary converter (1) to an electrical power source, on the one hand, and to at least one electric charge, on the other hand, and cables connecting the connectors to the functional modules (15) of the auxiliary converter (1) mounted in said at least one moving part (30) of the box (10).

6. The box (10) according to any one of claims 1 to 5, wherein, the box (10) being mounted on a railway vehicle, the wall (52) of the moving part (30) on which the functional modules (15) of the auxiliary converter (1) are mounted is substantially horizontal in the second position of said moving part.

7. The box (10) according to any one of claims 1 to 6, wherein a wall (52) of the moving part (30, 31, 32), on a first face of which the functional modules (15) of the auxiliary converter (1) are mounted, is provided, on its second face, with at least one cooling device (16).

8. An auxiliary converter (1) for a railway vehicle, **characterized in that** it is of the modular type, that is to say, each of the functions of which is performed by an associated functional module (15), and **in that** it includes a box (10) according to any one of claims 1 to 7, each of the functional modules (15) of the converter being fastened on a wall (52) of a moving part (30, 31, 32) of the box (10) that is oriented toward the inside of the box (10) in the first position of said moving part.
